# DEMANDE DE BREVET EUROPEEN

(11) **EP 1 085 791 A1**
(43) Date de publication de la demande: **21.03.2001**
(21) Numéro de dépôt: 00402575.5
(22) Date de dépôt: 18.09.2000
(51) Int. Cl.: H05K 3/32, H01M 2/22

(54) **Système de liaison électrique entre un générateur électrochimique et un circuit imprimé**

(30) Priorité: 20.09.1999 FR 9911728
(71) Demandeur: ALCATEL, 75008 Paris (FR)
(72) Inventeur: Nadeau, Eric, 86800 Savigny L'Evescault (FR); Demarty, Dominique, 86360 Chasseneuil (FR); Gonin, Christian, 86600 Coulombiers (FR)
(74) Mandataire: Laroche, Danièle

(57) **Abrégé**

La présente invention a pour objet un système de liaison électrique entre un générateur électrochimique (2) et un circuit imprimé (10) comportant une couche de cuivre (12), ledit système comprenant au moins une connexion soudée sur ledit générateur (2), caractérisé en ce que ladite couche de cuivre (12) a une épaisseur supérieure à 70µm et en ce que une pièce métallique (3,4), reliée électriquement à ladite connexion (6,8), est fixée sur ladite couche de cuivre (12) par soudage (14) sans métal d'apport.

## Description

La présente invention concerne un système de liaison électrique entre un générateur électrochimique et la piste en cuivre d'un circuit imprimé. Elle s'étend en outre au procédé de réalisation d'une telle liaison.

La sortie ou l'entrée du courant dans un générateur électrochimique s'effectue au moyen des bornes de polarité respectivement négative et positive qui en sont issues. Lorsque les générateurs sont assemblés en batterie, ils sont électriquement reliés entre eux en série ou en parallèle. Cette liaison entre les générateurs s'effectue le plus souvent par l'intermédiaire d'une carte électronique portant un circuit imprimé d'interconnexion. Cette carte est généralement destinée à l'insertion d'un dispositif de sécurité électronique dans la batterie.

Sur la borne du générateur électrochimique on soude un dispositif de connexion, comportant une ou plusieurs pièces électriquement solidaires, dont l'extrémité opposée est brasée à l'étain sur la couche de cuivre constituant la piste du circuit imprimé. On entend par brasage une opération consistant à assembler des pièces métalliques à l'aide d'un métal d'apport ayant une température de fusion inférieure à celle des pièces à réunir. La liaison par brasage sur la couche de cuivre s'effectue la plupart du temps à l'aide de conducteurs souples.

La réalisation d'une telle liaison avec apport d'étain comporte des inconvénients qui peuvent rendre inutilisables, voire dangereuses, de nombreuses batteries. En particulier il peut se produire des projections de matière sur la carte électronique durant l'opération de brasure qui sont susceptibles de détériorer un composant ou de provoquer ultérieurement des courts-circuits. En outre on a constaté une migration ultérieure de l'étain qui peut aussi être à l'origine de courts-circuits.

D'autre part l'utilisation de fils souples présente au montage un risque d'inversion des fils. En outre la liaison par des fils souples rend plus difficile l'automatisation des opérations de fabrication et nécessite la multiplication des contrôles.

La présente invention a pour but de proposer un système de liaison électrique entre un générateur électrochimique et un circuit imprimé qui soit plus fiable que le système connu tant vis à vis du taux de déchet en fabrication que de la durée de vie de la batterie.

L'objet de la présente invention est un système de liaison électrique entre un générateur électrochimique et un circuit imprimé comportant une couche de cuivre, ledit système comprenant au moins une connexion soudée sur ledit générateur, caractérisé en ce que ladite couche de cuivre a une épaisseur supérieure à 70µm et en ce que une pièce métallique, reliée électriquement à ladite connexion, est fixée sur ladite couche de cuivre par soudage sans métal d'apport.

On entend par soudage une opération consistant à réunir des pièces métalliques de manière à assurer la continuité, notamment électrique, entre ces pièces. Ici la soudure s'effectue sans métal d'apport par fusion et/ou par pression.

Lorsque la couche de cuivre est épaisse de 70µm ou moins, la soudure ne peut être effectuée. Dans ce cas on observe une fusion ou un décollement. La couche de cuivre a de préférence une épaisseur au moins égale à 105µm.

La pièce métallique a une épaisseur au moins égale à 80µm, et de préférence comprise entre 80µm et 200µm. Selon une forme particulière de réalisation de l'invention, ladite pièce a une épaisseur au moins égale à 100µm, et de préférence comprise entre 125µm et 140µm.

La pièce métallique est une pièce conductrice constituée d'un métal choisi parmi le nickel, l'acier nickelé, l'acier inoxydable et le cuivre.

Selon une forme particulière de réalisation de l'invention, ladite pièce est ladite connexion elle-même. Mais la pièce en nickel peut aussi être reliée au générateur par l'intermédiaire d'une ou plusieurs pièces, la continuité électrique étant assurée par soudage de ces pièces entre elles. Notamment la pièce métallique peut être soudée sur la connexion, elle-même en nickel, en acier ou acier nickelé. Ainsi la continuité électrique entre le générateur et le circuit d'interconnexion est assurée uniquement par des soudures sans métal d'apport.

La présente invention a comme avantage de rendre plus simple, plus fiable et moins onéreuse la mise en batterie de générateurs électrochimiques, notamment en réduisant d'environ 60% le temps de soudage et en divisant par 10 le taux de déchets dû aux erreurs de montage ou à la détérioration des circuits électroniques. En outre l'automatisation des opérations de montage en est facilité.

La soudure obtenue peut être caractérisée par les méthodes usuelles, principalement ses propriétés électriques par la mesure de la résistance ohmique, et mécaniques par la mesure de la résistance à l'arrachement sous un effort de traction perpendiculaire ou la mesure de la résistance au cisaillement sous un effort de traction axial.

La résistance de liaison après soudure de ladite pièce sur ladite couche de cuivre est au plus égale à 0,07Ω pour un courant de 5A.

La résistance à l'arrachement après soudure de ladite pièce sur ladite couche de cuivre est au moins égale à 1,5daN, et la résistance au cisaillement est au moins égale à 8daN.

L'invention a aussi pour objet un générateur électrochimique relié à un circuit imprimé par un tel système de liaison électrique et une batterie de tels générateurs électrochimiques. Il peut s'agir aussi bien d'une batterie de générateurs primaires ou secondaires. Par exemple l'invention s'applique à des générateurs à électrolyte organique comme les générateurs primaires LiSO2 ou les générateurs secondaires Lithium-Ion, ou bien encore à des générateurs à électrolyte aqueux comme les générateurs secondaires Nickel-Cadmium ou Nickel-Métal Hydrurable. Les générateurs peuvent être de forme cylindrique ou prismatique. Le nombre de générateurs constituant la batterie n'est pas limité. Les générateurs peuvent être raccordés en série et/ou en parallèle.

L'invention a encore pour objet un procédé de fabrication d'un système selon l'une des revendications précédentes, dans lequel ladite pièce est soudée par résistance sur ladite couche de cuivre. De préférence la soudure par résistance est une soudure par points.

La soudure par points est réalisée avec des électrodes de forme cylindrique ayant un diamètre de l'ordre de 1,2mm. Les électrodes sont de préférence en cuivre ou alliage de cuivre.

La soudure est réalisée avec une puissance électrique comprise entre 50W/s et 80W/s. La durée totale de réalisation de ladite soudure est bien inférieure à la seconde.

La soudure est réalisée sous une pression comprise entre 60N/mm² et 80N/mm².

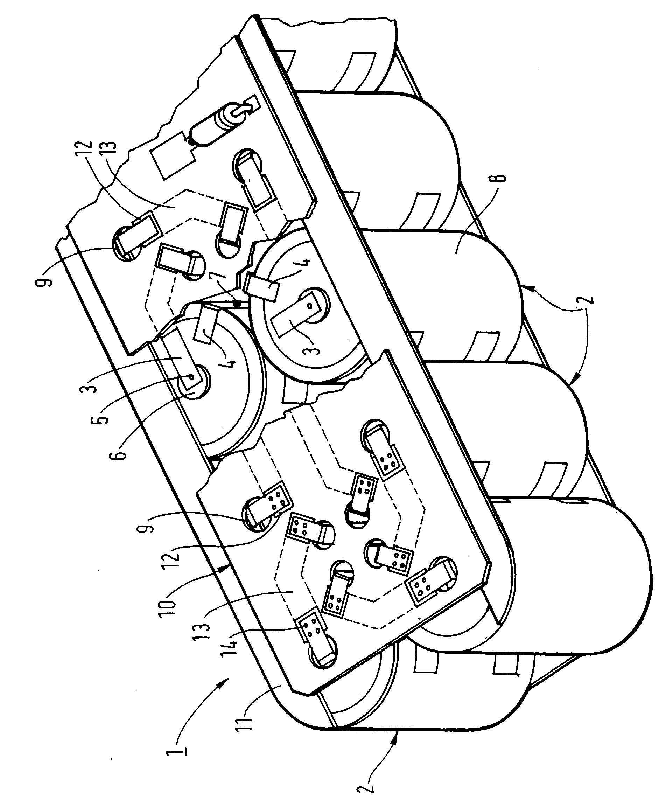

L'invention sera mieux comprise et d'autres avantages et particularités apparaîtront à la lecture de la description qui va suivre, donnée à titre illustratif, mais nullement limitatif en référence au dessin annexé dans lequel la figure unique représente une batterie de générateurs montrant différents états d'avancement de la réalisation du système de liaison électrique selon la présente invention.

La batterie 1 selon l'invention comporte dix générateurs électrochimiques 2 par exemple de type Lithium-Ion. De chaque générateur 2 sortent une connexion positive 3 et une connexion négative 4. Chaque connexion positive 3 est soudée en 5 sur le plot conducteur 6 constituant le pôle positif du générateur 2 et chaque connexion négative 4 est soudée en 7 sur le conteneur 8 du générateur qui en constitue le pôle négatif, comme représenté dans la partie centrale de la figure.

Les connexions 3, 4 en nickel sont introduites dans les passages 9 ménagés dans la carte électronique 10 qui est séparée des générateurs par un matériau isolant 11, puis repliées sur la couche de cuivre 12 de la piste 13 correspondante du circuit imprimé, comme le montre la partie droite de la figure. La connexion 3, 4 est alors soudée par points en 14 sur la couche de cuivre 12, comme le montre la partie gauche de la figure.

Un système de liaison conforme à la présente invention a été réalisé en utilisant des connexions en nickel d'origine et/ou d'épaisseur différentes (essais A à C). Les caractéristiques et résultats de ces essais sont rassemblés dans le tableau ci-dessous.

**TABLEAU**

| Essai | A | B | C |
|---|---|---|---|
| épaisseur Ni (µm) | 0,125 | 0,127 | 0,140 |
| épaisseur Cu (µm) | 105 | 105 | 105 |
| forme électrode | cylindre | cylindre | cylindre |
| diamètre électrode (mm) | 1,2 | 1,2 | 1,2 |
| pression (N / mm²) | 71 | 71 | 71 |
| intensité (A) ou puissance (W / s) | 50W/s | 80W/s | 80W/s |
| arrachement (daN) | 2,8-2,5 | 2-2,1 | 2-1,6 |
| cisaillement (daN) | 14,4 | 9,9 | 9,5 |
| résistance (mΩ) | <0,07 | <0,07 | <0,07 |

Les caractéristiques mécaniques et électriques des soudures réalisées dans les exemples ci-dessus correspondent à celles attendues par l'utilisateur.

## Revendications

1. Système de liaison électrique entre un générateur électrochimique et un circuit imprimé comportant une couche de cuivre, ledit système comprenant au moins une connexion soudée sur ledit générateur, caractérisé en ce que ladite couche de cuivre a une épaisseur supérieure à 70µm et en ce que une pièce métallique, reliée électriquement à ladite connexion, est fixée sur ladite couche de cuivre par soudage sans métal d'apport.

2. Système selon la revendication 1, dans lequel ladite couche de cuivre a une épaisseur au moins égale à 105µm.

3. Système selon l'une des revendications 1 et 2, dans lequel ladite pièce a une épaisseur au moins égale à 80µm.

4. Système selon la revendication 3, dans lequel ladite pièce a une épaisseur comprise entre 80µm et 200µm.

5. Système selon l'une des revendications 3 et 4, dans lequel ladite pièce a une épaisseur au moins égale à 100µm.

6. Système selon la revendication 5, dans lequel ladite pièce a une épaisseur comprise entre 125µm et 140µm.

7. Système selon l'une des revendications précédentes, dans lequel ladite pièce est constituée d'un métal choisi parmi le nickel, l'acier nickelé, l'acier inoxydable et le cuivre.

8. Système selon l'une des revendications précédentes, dans lequel ladite pièce est ladite connexion elle-même.

9. Système selon l'une des revendications précédentes, dans lequel la résistance de liaison après soudure de ladite pièce sur ladite couche de cuivre est au plus égale à 0,07 pour un courant de 5A.

10. Système selon l'une des revendications précédentes, dans lequel l'effort d'arrachement après soudure de ladite pièce sur ladite couche de cuivre est au moins égal à 1,5daN.

11. Système selon l'une des revendications précédentes, dans lequel l'effort de cisaillement après soudure de ladite pièce sur ladite couche de cuivre est au moins égal à 8daN.

12. Générateur électrochimique relié à un circuit imprimé par un système de liaison électrique selon l'une des revendications précédentes.

13. Batterie de générateurs électrochimiques comportant un système de liaison électrique selon l'une des revendications 1 à 1 1.

14. Procédé de fabrication d'un système de liaison électrique selon l'une des revendications 1 à 11, dans lequel ladite pièce est soudée par résistance sur ladite couche de cuivre.

15. Procédé selon la revendication 14, dans lequel ladite pièce est soudée par points sur ladite couche de cuivre.

16. Procédé selon l'une des revendications 14 et 15, dans lequel ladite soudure est réalisée avec des électrodes de forme cylindrique ayant un diamètre de l'ordre de 1,2mm.

17. Procédé selon l'une des revendications 14 à 16, dans lequel ladite soudure est réalisée avec une puissance comprise entre 50W/s et 80W/s.

18. Procédé selon l'une des revendications 14 à 17, dans lequel ladite soudure est réalisée sous une pression comprise entre 60N/mm² et 80N/mm².
